Europäisches Patentamt

European Patent Office

Office européen des brevets

Veröffentlichungsnummer: **0 283 529**

**A1**

# EUROPÄISCHE PATENTANMELDUNG

Anmeldenummer: 87104240.4

Int. Cl.⁴ **H03L 1/02**

Anmeldetag: 23.03.87

Veröffentlichungstag der Anmeldung:
28.09.88 Patentblatt 88/39

Benannte Vertragsstaaten:
**AT BE CH DE FR GB IT LI LU NL SE**

Anmelder: **BRG Mechatronikai Vállalat**
**Polgár u. 8-10**
**H-1033 Budapest(HU)**

Erfinder: **Ferenc, Nagy**
**Nyilhegy u.12**
**H-1165-Budapest(HU)**
Erfinder: **János, Mészáros**
**Szentendrei ut 10**
**H-1035 Budapest(HU)**
Erfinder: **Andor, Halász**
**Márvány u.26**
**H-1126 Budapest(HU)**
Erfinder: **Lásló, Szabó**
**Zuzmara u.7**
**H-1037 Budapest(HU)**

Vertreter: **Patentanwälte Viering & Jentschura**
**Steinsdorfstrasse 6**
**D-8000 München 22(DE)**

Schaltungsanordnung zur Temperaturkompensation der Frequenz von in AT-Richtung geschnittene Kristalle aufweisenden Oszillatoren, sowie Verfahren zur Einstellung der Kompensation.

Schaltungsanordnung zur Temperaturkompensation von in einem gegebenen Schnittwinkelbereich liegende, in AT-Richtung geschnittene Kristalle aufweisenden Oszillatoren, welche ein die Frequenz des Kristalls geringmässig beeinflussendes spannungsgesteuertes Abstimmelement, sowie zwei solche Temperaturkompensationsschaltungen (16, 18) aufweist, die mit dem Kristall thermisch gekoppelt sind und eine zur Kompensation der Temperaturabhängigkeit der den beiden Grenzschnittwinkeln des erwähnten Schnittwinkelbereiches zugeordneten Kristallen geeignete Kompensationsspannung erzeugen, die Schaltungsanordnung weist weiterhin ein lineares Interpolationselement (14) mit stellbarem Proportionalitätsfaktor auf, dessen zwei Eingänge jeweils mit den Ausgängen der Temperaturkompensationsschaltungen (16, 18) verbunden sind, während der Ausgang des Interpolationselementes (14) an dem die Frequenz des Oszillators beeinflussenden Abstimmelement (12) angeschlossen ist, wobei dieser Ausgang die auf den Schnittwinkel des gegebenen Kristalls abgestimmt gewogene Summe der beiden Kompensationsspannungen liefert. Die Temperaturkompensationsschaltungen sind auch für mehrere Oszillatoren verwendbar.

Bei dem zur Einstellung der Temperaturkompensation der Schaltungsanordnung dienenden Verfahren wird in einem ersten Schritt die Anordnung auf eine Temperatur von ca. 25°C gebracht und die Frequenz des Oszillators bei einer Mittelstellung des Interpolationselementes mit Hilfe eines von dem Interpolationselement separierten Abstimmelementes auf die nominale Frequenz des Kristalles eingestellt, danach wird die Temperatur wesentlich geändert und die Frequenz mittels des linearen Interpolationselementes auf den gleichen Wert eingestellt.

Fig.3

## Schaltungsanordnung zur Temperaturkompensation der Frequenz von in AT-Richtung geschnittene Kristalle aufweisenden Oszillatoren, sowie Verfahren zur Einstellung der Kompensation

Die Erfindung betrifft die Temperaturkompensation der Frequenz von in AT-Richtung geschnittene Kristalle aufweisenden Oszillatoren.

Die Eigenschaften der Kristalloszillatoren und verschiedene Möglichkeiten der Temperaturkompensation der Schwingfrequenz sind in dem Fachbuch 'Crystal Design and Temperatur Compensation', M.E. Frerking (Van Nostard Reinhold Co. New York, 1978) ausführlich und umfassend beschrieben.

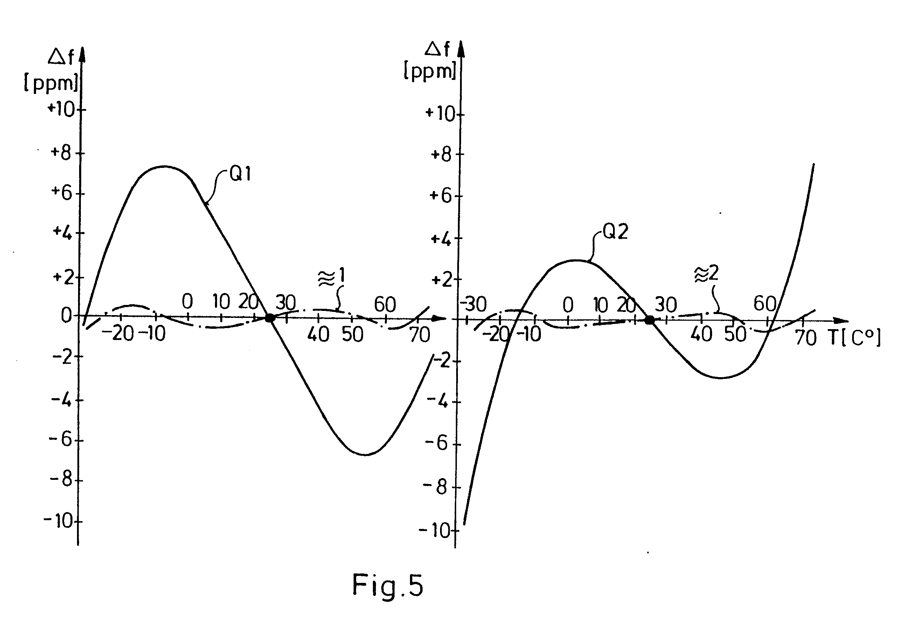

Unter den verschiedenen Schnittmöglichkeiten der Kristalle wird der AT-Schnitt am meisten verbreitet verwendet. Die Frequenz derart geschnittener Kristalle, die für die gleiche Frequenz gefertigt sind, ändert sich mit der Temperatur des Kristalles, wobei diese Aenderung mit einer kubischen Funktion angenähert werden kann. Die Form der Funktion hängt in bedeutendem Messe von dem tatsächlichen Wert des Schnittwinkels ab. Die Figuren 5 und 6 in dem genannten Buch veranschaulichen die relative Frequenzänderung für den Winkelbereich von 35°05′ und 35°30′ in einem Temperaturbereich von -60°C bis +100°C, wobei diese Frequenzänderung in einen Bereich von +100 bis -100 ppm (parts per million) fällt. Die kubische Funktion weist einen Inflexionspunkt und zwei Extremwerte auf, in Abhängigkeit von dem Schnittwinkel wechselt die Kurve das Vorzeichen und bei einem gegebenen Schnittwinkel liegt die Tangente in dem Inflexionspunkt waagerecht.

Die waagerechte Tangente bedeutet gleichzeitig, dass die Frequenz der auf diese Weise geschnittenen Kristalle in einem relativ weiten Temperaturbereich konstant ist oder sich nur geringmässig ändert. Die die Kristalle herstellenden Firmen sind bestrebt, in erster Linie die Kristalle mit einem derartigen Schnittwinkel herauszuschneiden, bei der derzeitigen Fertigungstechnologie kann jedoch der Schnittwinkel der Kristalle unter Beachtung der Gesichtspunkte der Wirtschaftlichkeit nur mit einem Toleranzbereich von ca. 5′ garantiert werden.

Bei mit einer derartigen Toleranz geschnittenen Kristallen liegt die Frequenzgenauigkeit innerhalb des Temperaturbereiches von -20°C bis +70°C bei ±10 ppm. Eine höhere Genauigkeit kann durch Sortieren der gefertigten Kristalle erreicht werden, was nicht nur zeitaufwendig, sondern auch unwirtschaftlich ist. Das ist der Grund dafür, dass der Preis der Kristalle mit Verringerung der Temperaturabhängigkeit steil ansteigt.

Kristalloszillatoren werden im allgemeinen dort verwendet, wo eine grosse Frequenzgenauigkeit erforderlich ist. In den verschiedenen Nachrichtenübertragungssystemen besteht die Anforderung, die Frequenzgenauigkeit möglichst in den Grenzen von 1-1,5 ppm zu halten, währen sich die Aussentemperatur in den Grenzen von -25°C bis +80°C ändern kann. Derartige Anforderungen hinsichtlich der Frequenzgenauigkeit sind auch bei einer Reihe anderer Anwendungsgebiete aufzufinden.

Zur Reduzierung der Temperaturabhängigkeit der Frequenz von Kristalloszillatoren hat sich eine Reihe verschiedener Kompensationslösungen verbreitet. Die herkömmliche Lösung, bei welcher der Kristall in einem Thermostat angeordnet wurde, geriet infolge des relativ grossen Platzbedarfes des Thermostats, sowie des bedeutenden Energieverbrauches immer mehr in den Hintergrund. Aus dem erwähnten Fachbuch ist eine Reihe von Kompensationsmethoden und Schaltungen bekannt geworden. Derartige Lösungen können in Abhängigkeit von ihrem Aufbau analoge oder digitale Systeme bilden, deren Funktionsprinzip darauf beruht, dass die Frequenz des den Kristall beinhaltenden Oszillators mittels eines reaktiven Elementes in Abhängigkeit von der Temperatur in einer zur natürlichen Frequenzänderung entgegengesetzten Richtung und einem dieser entsprechenden Mass gezogen wird, wodurch eine geringere Abhängigkeit der wirklichen Schwingfrequenz von der Temperatur erzielt wird.

Für eine analoge Temperaturkompensation ist ein Lösungsbeispiel aus der US-PS 4.051.446 bekannt geworden, bei welchem die kubische Kompensationskurve durch Addition mehrerer eine unterschiedliche Steilheit aufweisenden temperaturabhängigen Schaltungen ausgebildet wird. Ein anderes Lösungsbeispiel ist aus der US-PS 4.072.912 bekannt, bei welchem die Annäherungscharakteristik auch in mathematischer Form ausgedrück wird und die Koeffizienten mit den Elementen der gegebenen Schaltung eingestellt werden. Die Einstellung ist dabei sehr zeitaufwendig, da jeder Kristall in dem gesamten Temperaturbereich durchgemessen wird und die Parameter der Kompensationsschaltung in Abhängigkeit von dem tatsächlichen Verhalten des Kristalls eingestellt werden.

In einem mehrkanäligen UKW-Radiogerät werden zum Beispiel 10-12 Kristalloszillatoren verwendet und eine entsprechend stabile Frequenz kann nur in dem Falle gewährleistet werden, wenn für jeden einzelnen Oszillator (Kristall) jeweils eine dazu angepasste Kompensationsschaltung verwendet wird.

Aus Obigem folgt, dass die Kosten der Oszillatoren, die eine hohe Frequenzgenauigkeit sichern und in einem wei ten Betriebstemperaturbereich funktionieren, infolge des mit der Temperaturkompensation verbundenen Material-und Arbeitsaufwandes äusserst hoch sind.

Die mit der Erfindung zu lösende Aufgabe besteht in der Schaffung einer Schaltungsanordnung und eines Kompensationsverfahrens, welche das Erreichen der Temperaturunabhängigkeit der Frequenz von in AT-Richtung geschnittenen Kristallen vereinfachen.

Durch die Erfindung wurde eine Schaltungsanordnung zur Temperaturkompensation der Frequenz von in einem vorgegebenen Schnittwinkelbereich in AT-Richtung geschnittene Kristalle aufweisenden Oszillatoren geschaffen, welche eine die Frequenz des Kristalls geringmässig beeinflussendes, spannungsgesteuertes Abstimmelement, und eine Temperaturkompensationsschaltung aufweist, die mit dem Kristlal thermisch gekoppelt ist und an ihrem Ausgang eine temperaturabhängige Kompensationsspannung erzeugt, wobei dieser Ausgang mit dem Abstimmelement verbunden ist, und gemäss der Erfindung zwei Temperaturkompensationsschaltungen aufweist, die eine zur Kompensation der Temperaturabhängigkeit der in dem erwähnten Schnittwinkelbereich zu den beiden Grenzschnittwinkeln gehörenden Kristalle geeignete Kompensationsspannung erzeugen, dass die Schaltungsanordnung weiterhin ein lineares Interpolationselement mit einstellbarem Proportionalitätsfaktor aufweist, dessen zwei Eingänge mit den Ausgängen der beiden Temperaturkompensationsschaltungen verbunden sind und dessen Ausgang, der eine mit dem Schnittwinkel des gegebenen Kristalls in Übereinstimmung gewogene Summe der beiden Kompensationsspannungen liefert, an dem Abstimmelement angeschlossen ist.

Die Anwendung des linearen Interpolationselementes wurde durch die Tatsache ermöglicht, dass in der die Temperaturabhängigkeit der Kristalle ausdrückenden kubischen Funk tion die Koeffizienten linear von dem Schnittwinkel abhängen, demzufolge kann aus der gewogenen Summe der den beiden Grenzschnittwinkeln zugehörigen Kompensationsspannungen die Temperaturabhängigkeit der Kristalle mit beliebigem dazwischenliegenden Schnittwinkeln kompensiert werden.

Bei einer bevorzugten Ausführungsform der Erfindung wird das lineare Interpolationselement durch ein Potentiometer gebildet während das Abstimmelement eine Kapazitätsdiode bildet.

Hinsichtlich der entsprechenden Einstellbarkeit ist es von Vorteil, wenn in dem Oszillator der Kristall mit einer stellbaren Induktivität in Reihe geschaltet ist und der Oszillator auf der Frequenz der dritten Harmonischen des Kristalls schwingt. Diese zuletzt genannte Bedingung erfordert den Einbau solcher Schaltungselemente in die Schaltung des Oszillators. die die Schwingungen der ersten Harmonischen verhindern.

Durch die erfindungsgemässe Lösung kann nicht nur die Frequenz eines Oszillators. sondern auch die mehrerer Oszillatoren kompensiert werden, wenn diese thermisch unter gleichen Bedingungen angeordnet sind und jeder der Oszillatoren einen dem erwähnten Winkelbereich entsprechend herausgeschnittenen Kristall enthält und mit einem Abstimmelement versehen ist und gemäss der Erfindung den einzelnen Oszillatoren jeweils ein Interpolationselement zugeordnet ist. welche gemeinsamen an den beiden erwähnten Temperaturkompensationsschaltungen angeschlossen sind. Die gemeinsame Kompensation mehererer Oszillatoren ergibt eine bedeutende - schaltungstechnische Einsparung im Vergleich mit den früher je Oszillator gesondert verwendeten Kompensationslösungen.

Die Erfindung betrifft weiterhin ein Verfahren zur Ein stellung der Temperaturkompensation der beschriebenen Schaltungsanordnung, bei welchem sich die Frequenz-Temperatur-Charakteristiken der in dem erwähnten Schnittwinkelbereich liegenden Kristalle schneiden und gemäss der Erfindung im ersten Verfahrensschritt die Anordnung auf eine dem Schnittpunkt der Charakteristiken zugerörige Temperatur geführt wird und nach dem Erreichen des thermischen Gleichgewichtes die Frequer_ des Oszillators (vorzugsweise bei einer Mittelstellung des Interpolationselementes) mittels eines von dem Interpolationselement separierten Abstimmelementes auf die nominale Frequenz des Kristalles eingestellt wird, danach die Temperatur um einen Wert verändert wird, der mindestens dem Drittel der auf den augenblicklichen Wert bezogenen grössten Betriebstemperaturdifferenz entspircht, und nach dem Erreichen des thermischen Gleichgewichtes mittels des linearen Interpolationselementes die Frequenz auf den gleichen Wert eingestellt wird. Infolge der linearen Funktionsverbindung ist es ausreichend auf der Kompensationskurve des jeweiligen Kristalls einen einzigen Pukt einzustellen, zur Verringerung des Fehlers ist es jedoch von Vorteil, wenn dieser Punkt unabhängig von dem Schnittwinkel von der ersten Einstellungstemperatur weitmöglichst entfernt ist.

Die Genauigkeit kann dadurch erhöht werden, wenn die zweite Temperatur auf einen der Grenzwerte der Betriebstemperatur eingestellt wird.

Hinsichtlich der Einstellung ist die Ausführung von Vorteil, bei der mit dem Kristall einen stellbare Induktivität in Reihe geschaltet ist und in dem ersten Schritt die Frequenz durch Aenderung der Induktivität eingestellt wird.

Der Zeitbedarf des vorgeschlagenen Kompensationsverfahrens ist weitaus geringer als der der bekannten. bei mehreren Temperaturen individuelle Einstellungen beanspruchenden Lösungen. wodurch die Fertigung vereinfacht wird. die Kosten reduziert werden und die die Möglichkeit des Auftretens von subjektiven Einstellungsfehlern ausgeschlossen wird.

Nachstehend wird die Lösung gemäss der Erfindung anhand von Ausführungsbeispielen unter Bezugnahme auf die beigefügte Zeichnung näher beschrieben.

In der Zeichnung zeigen:

Fig. 1 die Aenderung der Kompensationsspannung in Abhängigkeit von der Temperatur für Kristalle mit drei verschiedenen Schnittwinkeln,

Fig. 2 ein Funktionsblockschema der erfindungsgemässen Schaltungsanordnung,

Fig. 3 ein Anordnungsschema der gemeinsamen Temperaturkompensation mehrerer Oszillatoren,

Fig. 4 ein ausführliches Schaltungsbild eines in der erfindungsgemässen Schaltungsanordnung vorzugsweise verwendbaren Oszillators, und

Fig. 5 Frequenz-Temperatur-Charakteristiken kompensierter und nicht kompensierter Oszillatoren.

Aus der Fachliteratur ist bekannt, dass die Temperaturabhängigkeit der Frequenz der in AT-Richtung geschnittenen Kristalle durch eine kubischer Funktion ausgedrückt werden kann:

$$\Delta f/f = A_1(t\text{-}t_0) + A_2(t\text{-}t_0)^2 + A_3(t\text{-}t_0)^3 \quad (1)$$

In dieser Gleichung beinhalten die Koeffizienten $A_1$, $A_2$, $A_3$ den Schnittwinkel. Es soll nun angenommen werden, dass der Kristall in einer solchen Oszillatorschaltung als frequenzbestimmendes Element verwendet werden soll, deren augenblickliche Frequenz mittels einer Kapazitätsdiode beeinflusst werden kann. Bei Kenntnis der temperaturabhängigen Frequenzänderung des Kristalls, desweiteren anhand der auf die Frequenz ausgeübten Wirkung der Spannung der Kapazitätsdiode kann für jede Temperatur eine solche Spannung U ermittelt werden, welche die Wirkung der Temperaturänderung zu kompensieren in der Lage ist, d.h. bei welcher der Oszillator gerade auf der nominalen Frequenz - schwingt. Diese Spannung-Temperatur-Abhängigkeit ist bei jedem Schnittwinkel eine andere.

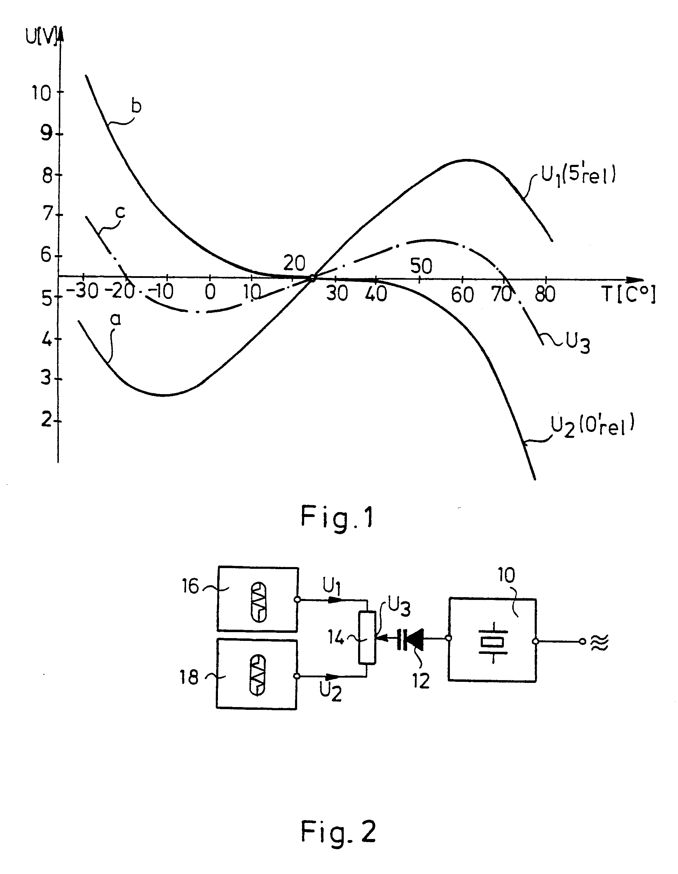

In der Fig. 1 zeigen die Kurven a und b zwei derartige Spannung-Temperatur-Kompensationsdiagramme. Die Diagramme, die den Verlauf der Spannungen $U_1$ bzw. $U_2$ veranschaulichen, gehören zu zwei solchen Kristallen, deren Schnittwinkel einen Unterschied von 5' aufweisen. Diese Differenz bedeutet gleichzeitig die einer vorgegebenen Genauigkeit (10 ppm) zugehörige grösste Winkeldifferenz. Wird einer gegebenen Frequenz z. B. ein Kristall mit einer Genauigkeit von 10 ppm zugeordnet, liegt der Schnittwinkel von jedem der gelieferten Kristalle innerhalb der gewählten zwei Grenzschnittwinkel.

Wie aus Fig. 2 ersichtlich ist. ist an einem kristallgesteuerten Oszillator 10 einen Kapazitätsdiode 12 angeschlossen. Die Kapazitätsdiode 12 erhält von dem Abgriff eines Potentiometers 14 eine Gleichspannung. wobei die beiden Enden des Potentiometers 14 an dem Ausgang jeweils einer Temperaturkompensationsschaltung 16 bzw. 18 angeschlossen sind. Die Temperaturkompensationsschaltungen 16 bzw. 18 sind auf die Weise ausgebildet und eingestellt. dass sie an ihren Ausgängen die Spannungen $U_1$ und $U_2$ gemäss dem Diagramm in Fig. 1 liefern. Die Temperaturkompensationsschaltungen 16 und 18 können durch beliebige bekannte Kompensationsschaltungen gebildet werden. Liegt der Schnittwinkel des in dem Oszillator 10 verwendeten Kristalls zwischen den beiden, den Temperaturkompensationsschaltungen 16 und 18 zugeordneten Grenzschnittwinkeln, verfügt das Potentiometer 14 mit Sicherheit über eine solche Stellung, bei welcher die an die Kapazitätsdiode 12 geschaltete Spannung $U_3$ zur Kompensation der Temperaturabhängigkeit dieses Kristalles geeignet ist, da die Koeffizienten der Gleichung (1) von dem Schnittwinkel linear abhängigen.

In Fig. 1 zeigt das Diagramm c die Spannung $U_3$, die sich auf ein Kristall .mit einem zwischenliegenden Schnittwinkel bezieht.

Die Einstellung des Potentiometers 14 kann bei einer einzigen Temperatur erfolgen. Der Einstellungsfehler ist dann am kleinsten, wenn die Einstellung bei einer Temperatur erfolgt, bei welcher die Differenz zwischen den Spannungen $U_1$ und $U_2$ am grössten ist. Das betrifft gemäss Fig. 1 eine Grenztemperatur. Bei der Einstellung wird der in dem Oszillator 10 befindliche Kristall mit den Temperaturkompensationsschaltungen 16 und 18 gemeinsam zum Beispiel auf eine Temperatur von 80°C erwärmt und nach Erreichen des thermischen Gleichgewichtes wird mit dem Potentiometer 14 die nominale Frequenz eingestellt. Danach gelangt an die Kapazitätsdiode 12 bei jeder Temperatur eine solche Kompensationsspannung, die die Temperaturabhängigkeit der Schwingfrequenz kompensiert.

Bei den bisher verwendeten Wärmekompensationslösungen war es ausreichend, eine einzige Kompensationsschaltung zu verwenden, so erscheint die Anwendung der vorgeschlagenen zwei Kompensationsschaltungen auf den ersten Blick als überflüssiger Mehraufwand. Bei den bekannten Lösungen musste jedoch die einzige Temperaturkompensationsschaltung entsprechend der Charakteristik des dazugeordneten Kristalls jeweils individuell eingestellt werden, dagegen beanspruchen die in Fig. 2 veranschaulichten Temperaturkompensationsschaltungen 16 und 18 keine individuelle Einstellung, da es ausreichend ist. bei den den Toleranzgrenzen eines Kristalltypes zugehörigen Kristallen ihre Elemente (oder bei digitaler Kompensation ihre Paramater) einmal einzustellen. Danach können die Temperaturkompensationsschaltungen 16, 18 in Serien hergestellt werden. Die einzige Einstellung, die bei jedem Kristall durchzuführen ist. ist die Bestimmung des Wertes des Potentiometers 14, was durch eine einzige Messung bei einer einzigen Temperatur leicht erfolgen kann. Durch die Vereinfachung der Einstellung kann im Vergleich mit dem sich aus der Verdoppelung der Kompensationsschaltungen ergebenden Aufwand eine weitaus höhere Einsparung erzielt werden.

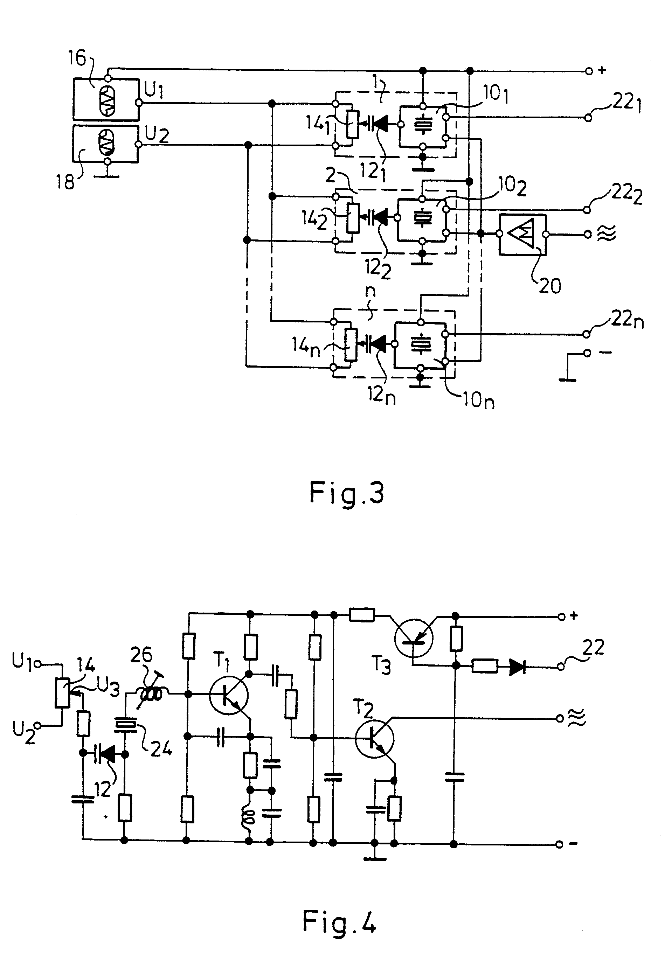

In Fig. 3 ist die gemeinsame Temperaturkompensation der in Sendern-Empfängern eines Funktelephones verwendeten n Oszillatoreinheiten veranschaulicht. In dem Gerät weisen die Einheiten 1, 2, ... n einen gleichen Aufbau auf, und sind in einem gemeinsamen Gehäuse angeordnet; sie unterscheiden sich nur in der nominalen Frequenz des verwendeten Kristalls voneinander. Die Enden der in den Einheiten befindlichen Potentiometer $14_1$, $14_2$,....$14_n$ sind parallel zwischen den Ausgängen der Temperaturkompensationsschaltungen 16, 18 geschaltet, d.h. an den Linien der Spannung $U_1$ und $U_2$ angeschlossen. Die Einheiten weisen jeweils einen Freigabeeingang $22_1$, $22_2$,....$22_n$ auf, die Steuerung des Gerätes sorgt für die Auswahl und Zulassung des jeweils erforderlichen Oszillators. Die Hochfrequenzausgänge der Oszillatoren sind an einer, die Ausgangssignale vereinigenden Einheit 20 angeschlossen.

Die Temperaturkompensation der n Oszillatoren kann durch eine Einpunkteinstellung der n Potentiometer realisiert werden, dazu ist es ausreichend, für alle Oszillatoren gemeinsam nur zwei Temperaturkompensationsschaltungen 16, 18 zu verwenden. Im Verhältnis zu der individuellen Kompensation ist hiermit nicht nur eine Verringerung der Einstell zeit sondern auch eine wesentliche - schaltungstechnische Einsparung zu verzeichnen. Die Anzahl n der Oszillatoren ist dabei praktisch nicht begrenzt.

In Fig. 4 ist das Schaltbild eines bevorzugten Ausführungsbeispieles des Oszillators 10 dargestellt. Diese Schaltung ist ein mit einem Transistor T1 modifizierter Clapp-Oszillator, wobei als gesondert anschliessbares Element der Kristall 24 vorgesehen ist, welcher mit einer stimmbaren Induktivität 26 in Reihe geschaltet ist. Ein in dem Emitterkreis des Transistors befindliches paralleles LC-Glied sorgt für das Ausschliessen der ersten Harmonischen, somit schwingt der Oszillator auf der Frequenz der dritten Harmonischen des Kristalls. Ein Transistor T2 sorgt für die Trennung des Ausganges, während ein Transistor T3 für das Ein-und Ausschalten sorgt. Die an den Freigabeeingang 22 geschaltete Spannung öffnet. bzw sperrt den Transistor T3.

Die in Fig. 4 veranschaulichte Schaltung kann auch in integrierter Ausführung realisiert werden. Die Abstimmung erfolgt auf die Weise. dass bei Mittelstellung des Potentiometers auf der dem Inflexionspunkt entsprechenden Temperatur von 25°C mittels der Induktivität 26 die gewünschte nominale Frequenz eingestellt wird. danacha bei einer den Grenztemperaturen. (vorzugsweise der oberen Grenztemperatur) die gleiche nominale Frequenz mit Hilfe des Potentiometers erneut eingestellt wird.

Es ist dabei zu bemerken. dass die Kompensation nur dann wirkungsvoll ist. wenn die Temperaturkompensationsschaltungen 16, 18 einer gleichen Temperatur ausgesetzt sind, z.B. zwischen ihnen eine thermische Kopplung besteht.

In Fig. 5 sind die Temperatur-Frequenz-Diagramme einiger mit Hilfe der erfindungsgemässen Schaltungsanordnung kompensierter Oszillatoren veranschaulicht. Als Resultat der Kom pensation konnte die Frequenzänderung um mehr als auf ein Fünftel reduziert werden. einer Frequenzänderung von 1 ppm ist dagegen ein weiterer Temperaturbereich (-25°C - +80°C) zugeordnet.

## Ansprüche

1. Schaltungsanordnung zur Temperaturkompensation der Frequenz von in AT-Richtung geschnittene, in einem vorgegebenen Schnittwinkelbereich liegende Kristalle aufweisenden Oszillatoren, welche ein die Frequenz des Kristalles geringfügig beeinflussendes, spannungsgesteuertes Abstimmelement und eine Temperaturkompensationsschaltung aufweist, und die Temperaturkompensationsschaltung mit dem Kristall thermisch gekoppelt ist und an ihrem Ausgang eine von der Temperatur abhängige Spannung liefert, wobei dieser Ausgang an dem Abstimmelement angeschlossen ist, dadurch gekennzeichnet, dass zwei Temperaturkompensationsschaltungen (16, 18) vorgesehen sind, die eine zur Kompensation der Temperaturabhängigkeit des in dem erwähnten Schnittwinkelbereich zu den beiden Grenzschnittwinkeln gehörenden Kristalls geeignete Kompensationsspannung erzeugen, dass die Schaltungsanordnung weiterhin ein lineares Interpolationselement (14) mit einstellbarem Proportionalitätsfaktor aufweist, dessen zwei Eingänge jeweils mit den Ausgängen der Temperaturkompensationsschaltungen (16, 18) verbunden sind, und dessen Ausgang, der eine in Übereinstimmung mit dem Schnittwinkel des gegebenen Kristalls gewogene Summe der beiden Kompensationsspannungen liefert, an dem Abstimmelement (12) angeschlossen ist.

2. Schaltungsanordnung nach Anspruch 1, dadurch gekennzeichnet, dass das lineare Interpolationselement durch ein Potentiometer (14) gebildet ist.

3. Schaltungsanordnung nach Anspruch 1 oder 2, dadurch gekennzeichnet, dass das Abstimmelement durch eine Kapazitätsdiode (12) gebildet ist.

4. Schaltungsanordnung nach Anspruch 3, dadurch gekennzeichnet, dass der Kristall (24) in dem Oszillator (10) mit einer stellbaren Induktivität (26) in Reihe geschaltet ist und der Oszillator auf der Frequenz der dritten Harmonischen des Kristalls schwingt.

5. Schaltungsanordnung nach einem der Ansprüche 1 bis 4, dadurch gekennzeichnet, dass mehrere (1...n) Oszillatoren ($10_1$, $10_2$ ....$10_n$) thermisch unter gleichen Bedingungen angeordnet sind, von denen jeder einen dem erwähnten Schnittwinkelbereich entsprechend herausgeschnittenen Kristall aufweist und mit je einem Abstimmelement versehen ist, dass weiterhin den einzelnen Oszillatoren ($10_1$, $10_2$, ...$10_n$) jeweils ein Interpolationselement ($14_1$, $14_2$,...$14_n$) zugeordnet ist, die gemeinsam an den beiden erwähnten Temperaturkompensationsschaltungen (16, 18) angeschlossen sind.

6. Verfahren zur Einstellung der Temperaturkompensation der Schaltungsanordnung gemäss einem der Ansprüche 1 bis 5, wobei die Frequenz-Temperatur-Charakteristiken der in dem erwähnten Schnittwinkelbereich liegenden Kristalle einander bei einer gegebenen Temperatur schneiden, dadurch gekennzeichnet, dass die Anordnung in einem ersten Schritt auf die dem Schnittpunkt der Charakteristiken zugehörige Temperatur gebracht wird und nach Erreichen des thermischen Gleichgewichtes die Frequenz des Oszillators mittels eines von dem Interpolationselement abgesonderten Abstimmelementes auf die nominale Frequenz des Kristalls eingestellt wird, dass danach die Temperatur um einen mindestens dem Drittel des Temperaturunterschiedes zwischen der augenblicklichen Temperatur und der davon am weitesten entfernten Grenztemperatur der Betriebstemperatur entsprechenden Wert verändert wird und nach der Einstellung des thermischen Gleichgewichtes die Frequenz mit Hilfe des linearen Interpolationselementes auf den gleichen Wert eingestellt wird.

7. Verfahren nach Anspruch 6, dadurch gekennzeichnet, dass in einem zweiten Schritt die Temperatur auf einen Grenzwert des Betriebstemperaturbereiches eingestellt wird.

8. Verfahren nach Anspruch 6 oder 7, dadurch gekennzeichnet, dass die Einstellung in dem ersten Schritt bei einer Mittelstellung des Interpolationselementes durchgeführt wird.

9. Verfahren nach einem der Ansprüche 6 bis 8, dadurch gekennzeichnet, dass mit dem Kristall (24) eine stellbare Induktivität (26) in Reihe geschaltet ist, und in dem ersten Schritt der Wert der Frequenz durch Aenderung der Induktivität (26) eingestellt wird.

Fig.1

Fig. 2

Fig.3

Fig.4

Fig.5

| Europäisches Patentamt | EUROPÄISCHER RECHERCHENBERICHT | Nummer der Anmeldung |
|---|---|---|
| | | EP 87 10 4240 |

## EINSCHLÄGIGE DOKUMENTE

| Kategorie | Kennzeichnung des Dokuments mit Angabe, soweit erforderlich der maßgeblichen Teile | Betrifft Anspruch | KLASSIFIKATION DER ANMELDUNG (Int. Cl.4) |
|---|---|---|---|
| A | GB-A-2 038 125 (NIPPON ELECTRIC) * Seite 1, Zeile 55 - Seite 4, Zeile 40; Figuren 1-5 * --- | 1,6 | H 03 L 1/02 |
| A | FR-A-2 437 731 (QUARTZ ET ELECTRONIQUE) * Seite 2, Zeile 1 - Seite 7, Zeile 9; Figur 1 * --- | 1,6 | |
| A,D | FR-A-2 309 075 (SONY) --- | | |
| A,D | US-A-4 072 912 (PRADAL) ----- | | |
| | | | **RECHERCHIERTE SACHGEBIETE (Int. Cl.4)** H 03 L H 03 B |

Der vorliegende Recherchenbericht wurde für alle Patentansprüche erstellt

| Recherchenort | Abschlußdatum der Recherche | Prüfer |
|---|---|---|
| DEN HAAG | 20-11-1987 | DHONDT I.E.E. |